(19) Europäisches Patentamt / European Patent Office / Office européen des brevets

(11) **EP 2 254 248 A1**

(12) **EUROPEAN PATENT APPLICATION**

(43) Date of publication:
**24.11.2010 Bulletin 2010/47**

(51) Int Cl.:
*H03M 5/14* (2006.01)   *G11B 20/14* (2006.01)

(21) Application number: **09305459.1**

(22) Date of filing: **19.05.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **Thomson Licensing**
**92130 Issy-les-Moulineaux (FR)**

(72) Inventors:
• **Chen, Xiao-Ming**
**30165 Hannover (DE)**

• **Theis, Oliver**
**30655 Hannover (DE)**
• **Timmermann, Friedrich**
**30823 Garbsen (DE)**

(74) Representative: **Thies, Stephan**
**Deutsche Thomson OHG**
**European Patent Operations**
**Karl-Wiechert-Allee 74**
**30625 Hannover (DE)**

(54) **Method for modifying a channel encoder finite state machine, and method for channel encoding**

(57) A method is disclosed for deriving channel encoder FSMs of improved noise resilience, as are several channel encoder FSMs derived therewith. In the method, RMTR paths (201) are identified for a given encoder FSM, state transitions of RMTR paths (201) are redirected into an added FSM state, and state transitions from the added state back into the FSM are selected in full search. Full search effort is reduced by applying skipping criteria, and improved noise resilience is achieved by minimizing the number of RMTR paths (201).

**Fig. 2**

**Description**

Field of the invention

The present invention relates to channel coding of digital data for high density storage media.

Background of the invention

For data storage using relative motion between a transducer and a storage medium, Run Length Limited, or RLL, codes are widely used. In these codes, the signal to be physically recorded has homogeneous regions whose length is between a lower limit and an upper limit. RLL codes are often described as being "(d,k)" codes, wherein d describes the minimum runlength and k describes the maximum runlength of the homogeneous regions. More specifically, because of an involved NRZI preprocessing step, changes in the signal to be recorded are considered and are described by a binary "1", and unchanged parts of the signal to be recorded are described by strings of binary "0". Noting that d specifically denotes the minimum runlength of these strings of "0" and k specifically denotes the maximum runlength of the strings of "0", it becomes evident that for a (d,k) code the length of the homogeneous regions is inclusively between (d+1) and (k+1).

In RLL codes, patterns having the minimum allowed runlength in a time or spatial domain correspond to signals having large components at high frequencies. Assuming a conceptually low-pass nature of a storage channel, such patterns will suffer most from high frequency attenuation and will be strongly affected by storage channel noise. As an approach to minimise these detrimental effects, codes obeying a limitation of the so-called Repeated Minimum Transition Runlength, or RMTR, have been disclosed. The maximum allowable repetition of the minimum allowable runlength in an RMTR limited RLL code is often denoted as "r", a code where up to but no more than 5 minimum runlength patterns may occur in direct consecution is denoted as "r=5".

In "Optical disc system for digital video recording," Narahara et al, Japanese Journal of Applied Physics, Volume JJAP-39, pp. 912-919, it is disclosed that in the context of optical data storage, minimum runlength symbols are especially critical under tangential tilt conditions. A so-called "(17)-PP" code is described, where the maximal RMTR is limited to r=6.

In **Coene et al, "A new d=1 k=10 soft-decodable RLL code with r=2 RMTR-constraint and a 2-to-3 PCWA mapping for DC-control", Proc. Optical Data Storage 2006,** a d=1, k=10, r=2 RLL code is proposed for high-density optical storage systems. Due to imposing the r=2 constraint, the code has an improved Bit Error Rate or BER and an improved timing recovery performance, compared to a (1,7) code without RMTR limitation.

Two known approaches exist for RLL encoding a sequence of infowords into a sequence of codewords; they are usually called look-ahead encoding and finite state machine or FSM encoding. Of these, FSM encoding has the advantage of being more regular in structure and therefore is often preferrable. An FSM channel encoder is completely described by a matrix of (next state,codeword) pairs covering all states and all distinct infowords; this matrix is called the state transition table of the encoder FSM. For an encoder FSM having 5 states and encoding 2 bit infowords, 4 distinct infowords exist, namely "00", "01", "10", and "11", so that the state transition table has 4*5 entries.

Both the (1,7)-PP code of Narahara, and the (1,10) r=2 codes of Coene et al, can be seen to have the drawback that they need look-ahead encoding, which increases encoding/decoding complexity considerably.

In unpublished European Patent Application EP 08305612, it is shown how to derive an FSM encodable RLL code with limited RMTRs by a state adding approach. Example codes of (1,8) or (1,9) RLL with r=5 are disclosed there.

In WO 06/030349 by Coene, starting from a State Transition Diagram or STD with d=1, r=2 constraints, RLL codes are designed by means of a so-called state splitting algorithm. After state splitting, the k-constraint is limited using substitutions. Two FSM encodable RLL codes suitable for soft-in soft-out decoding are proposed: The first code is a d=1, r=2, k=14, 4-to-6 RLL code. Encoding Finite State Machines and decoding Finite State Machines having 9 states and 144 state transitions are given. The second code is a d=1, r=2, k=12, 2-to-3 RLL code. Encoding and decoding FSMs having 11 states and 44 state transitions are given. This can be seen as a disadvantageously high complexity.

In WO 07/072277 by Coene et al., a similar design procedure as that of WO 06/030349 is used, i.e. it also starts from a (d,r)-constrained STD, while the k-constraint is limited afterwards using substitutions. An RLL code with d=1, r=2, k=10 is presented with an encoding FSM and substitution tables. This code can be seen to have the drawback that a look-ahead of 4 or 6 data bits is required for encoding.

The above mentioned **Coene et al, "A new d=1 k=10 soft-decodable RLL code with r=2 RMTR-constraint and a 2-to-3 PCWA mapping for DC-control", Proc. Optical Data Storage 2006,** discloses that Soft-Input Soft-Output or SISO decoding for the RLL code of WO 07/072277 can be accomplished using a tree-like structure or trellis with 9 states and 34 branches. This can be seen as a disadvantageously high complexity.

An improved channel coding is therefore desirable.

Invention

The aim of the invention is reached by a method of modifying a given encoder finite state machine of a channel code obeying a lower runlength limitation, an upper runlength limitation and having repeated minimum transition runlengths constrained to a maximum repetition, into a modified encoder finite state machine having improved noise resilience according to claim 1. The method comprises:

- identifying, as RMTR paths, those state transition sequences of the given encoder finite state machine, which generate a codeword sequence containing the maximum repetition of minimum transition runlengths;

- re-directing, in full search, state transitions of an identified RMTR path to an additional state;

- deriving the modified encoder finite state machine by selecting, from a set of assignments, a next state / codeword assignment for the additional state in full search.

In this, the step of selecting comprises:

- skipping those assignments where compliance with the lower runlength limitation is not guaranteed,

- skipping those assignments where an unlimited runlength may arise,

- skipping those assignments which may generate codeword sequences having a number of repeated minimum transition runlengths larger than the maximum repetition,

- skipping those assignments which may generate undistinguishable codeword sequences,

- selecting that assignment where the modified encoder finite state machine has the smallest maximum repetition, and

- selecting that assignment which minimizes the number of RMTR paths of the modified encoder finite state machine.

In this invention, it has been noticed that for high-density storage, even if the RMTR of a code can not be reduced any further in the strict sense of avoiding long minimum transition runlength repetitions altogether, it is still advantageous and desirable to at least minimize the occurrence probability of those maximal RMTR sequences. With other words, the invention solves the problem how to modify a given FSM RLL encoder with limited RMTRs to make the RMTR-constraint r as small as possible and to minimize the occurrence probability of the maximal RMTR sequences, if a reduction of the r-constraint is impossible.

It has also been noticed in this invention, that surprisingly the number of candidates to be inspected in a full search approach for completing the extended FSM is dramatically reduced by applying the skipping criteria mentioned above, which renders the full search approach apt for practical application.

Under the realistic assumption that all distinct infoword sequences are equiprobable, minimising the number of RMTR paths in the encoder FSM minimises the occurrence probability of the RMTR, which in turn minimizes high frequency content of the signal to be recorded, and thus improves the noise resilience of the storage channel.

In the following, the property of a code to have both, the minimum possible RMTR, and at the same time the minimum possible occurrence probability of the maximum allowable RMTR, will be denoted as the Minimal RMTR Constraint.

In this invention, starting from a (d, k, r)-constrained original code and its encoder FSM, states are being added to the FSM in order to minimize the r constraint, while the k-constraint is relaxed, i.e. while the k constraint is allowed to increase slightly. As examples, d=1, r=3, k=9, RLL codes are disclosed here, which are both FSM-encodable and FSM-decodable. No look-ahead is necessary for encoding, and the encoder FSM has 8 states and 32 state transitions.

According to this invention, FSM RLL encoders with the Minimal RMTR Constraint are designed as follows:

Step 1: Identify the state transition paths of the original code which result in the maximal RMTR.

Step 2: For each of the identified paths, use a state adding approach to re-direct state transitions along the path to reduce the maximal RMTR and to reduce the number of paths resulting in the maximal RMTR.

Step 3: Repeat Step 1 and Step 2, using as original codes those obtained in the preceding Step 2, until no further improvement is possible.

Using codes obeying a Minimal RMTR Constraint, improvement of system performance is expected for high-density storage systems at the expense of a slightly increased upper runlength limit and a slightly increased encoding/decoding complexity.

Advantages of the invention:

- The RMTR-constraint and the occurrence probability of maximal RMTR sequences are both minimized for the designed RLL codes.
- The designed RLL codes remain FSM encodable.
- The invented method automatically generates a set of FSM encodable RLL codes with different levels of RMTR-constraints.

Drawings

Exemplary embodiments of the invention are illustrated in the drawings and are explained in more detail in the following description.

In the figures:

**Fig. 1** shows the state transition diagram of a 5-state FSM encodable RLL code with d=1, r=5;

**Fig. 2** shows the encoding tree from state S1, based on the encoding FSM in Table 1;

Exemplary embodiments

An FSM encodable RLL code can be represented by a state transition table or by a state transition diagram. The state transition diagram can be employed to identify directed paths resulting in the maximal RMTR. Unlimited RMTRs, i.e. codes in whose output the minimum runlength pattern may occur in unlimited repetition, correspond to cyclic paths in the state transition diagram. The state transition diagram of an RMTR limited code does not have such cyclic paths - at least not at the minimum allowable runlength - and the finitely often repeated minimum runlength corresponds to a non-cyclic path in the state transition diagram.

In the following, RLL codes with rate 2/3 and d=1 will be considered as an embodiment of the invention. The known nomenclature of "rate 2/3" means that the code generates three output bits for every pair of input bits.

In the following, the input bit pairs will also be denoted as infowords, and the output bit triplets will also be denoted as codewords.

Note that the invention is also applicable to FSM encodable RLL codes with other code rates and other d-constraints. For codes having rate 2/3 and d=1, given a RMTR-limited FSM encodable RLL code, the search procedure for valid FSM encodable RLL codes with the Minimal RMTR Constraint is accomplished automatically, in the sense that it can be cast into a machine executable algorithm or method, and it is guaranteed to terminate successfully.

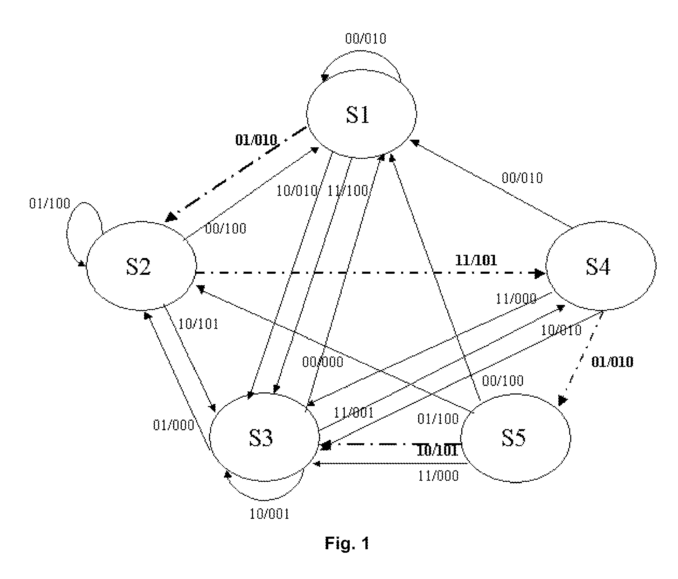

**Fig. 1** shows, as an example, the state transition diagram of a 5-state FSM encodable RLL code with r=5; Table 1 shows the corresponding state transition table. The code is identical to that disclosed in Table 3.1 of EP 08305612.

In **Fig. 1**, the states are symbolized by nodes denoted as "S1", "S2", "S3", "S4", and "S5". State transitions are symbolized as directed branches symbolized as arrows, and each arrow is labelled in the form "ii/ccc". In this, "ii" stands for the input bit pair or infoword, under whose occurrence the respective state transition is performed, and "ccc" stands for the output bit triplet or codeword that is being generated for the state transition. For example, the state transition arrow going from S1 back into S1 is ascribed "00/010", to denote that when the FSM is in S1 and an input bit pair of "00" is received, an output bit triplet of "010" is generated, and the FSM stays in S1. This corresponds to the top left entry of Table 1.

Table 1: State transition table of a (d=1, r=5, k=8) RLL code

|  | 00 | 01 | 10 | 11 |
|---|---|---|---|---|
| S1 | 010/S1 | **010/S2** | 010/S3 | 100/S3 |
| S2 | 100/S1 | 100/S2 | 101/S3 | **101/S4** |
| S3 | 000/S1 | 000/S2 | 001/S3 | 001/S4 |
| S4 | 010/S1 | **010/S5** | 010/S3 | 000/S3 |
| S5 | 100/S1 | 100/S2 | **101/S3** | 000/S3 |

In Table 1, the column headings denote the input bit pairs, and, as shown in the row headings at the left, the table rows correspond to the five states of the FSM. The 20 table entries each denote the output bit triplet to be outputted and the next state to be transited to. The 4 table entries shown in boldface and underlined are the constituents of the RMTR path of the code. With other words: Assuming that the encoder FSM is in state S1, then an input bit sequence of "01 11 01 10" will cause the encoder FSM to output the bit sequence "010 101 010 101" while stepping through the sequence of states S1, S2, S4, S5, S3. In **Fig. 1,** these state transitions are shown as dash-dotted arrows. The output bit sequence "010101010101" contains 5 instances of a single "0" surrounded by "1"s on both sides, which is the equivalent of a minimum runlength pulse in the signal to be recorded. The fact that none of the output bit triplets of S3 equals "010" illustrates that, whatever the next input bit pair, the repeated minimum transition run is reliably terminated in S3. Because of this property, the sequence of states S1, S2, S4, S5, S3 constitutes what will be called an RMTR path in the following.

In the following, it is shown how to modify the encoding FSM so that an FSM encodable RLL code with the Minimal RMTR Constraint can be obtained.

Repeated State Adding To Minimize RMTR-Constraint

The present invention designs an FSM encodable RLL code with the Minimal RMTR Constraint using the following three steps:

Step 1: Identify as RMTR paths those state transition paths of the encoding FSM that generate instances of the maximal RMTR output bit sequence.

FSM encoding in general can be visualized as an encoding tree, where each path in the encoding tree corresponds to a specific pair of an infoword sequence together with the associated codeword sequence. To find the maximum possible repetition of the minimum runlength, i.e. the maximal RMTR from a given starting state, all state transitions from that start state to a next state are examined as to whether or not the associated codeword prolongs the RMTR. Those of the state transitions, where the RMTR is not prolonged are not investigated any further. Those of the examined state transitions where the RMTR is prolonged, are retained, are memorized as candidate RMTR paths, and their next states are investigated in turn, using the same procedure, whether the RMTR can be prolonged any further with a subsequent state transition. With other words: Whenever, in traversing the encoding tree, an increase of the RMTR value for a path is not possible any more, that path is considered to be terminated. Whenever the last state transition prolongs the RMTR, the path is investigated further. This is performed for all states assumed as starting state. State transitions and codeword sequences of the encoding tree traversal paths under examination are stored. Because the RMTR of the original code is limited, it is guaranteed that all encoding tree traversal paths terminate after finitely many steps.

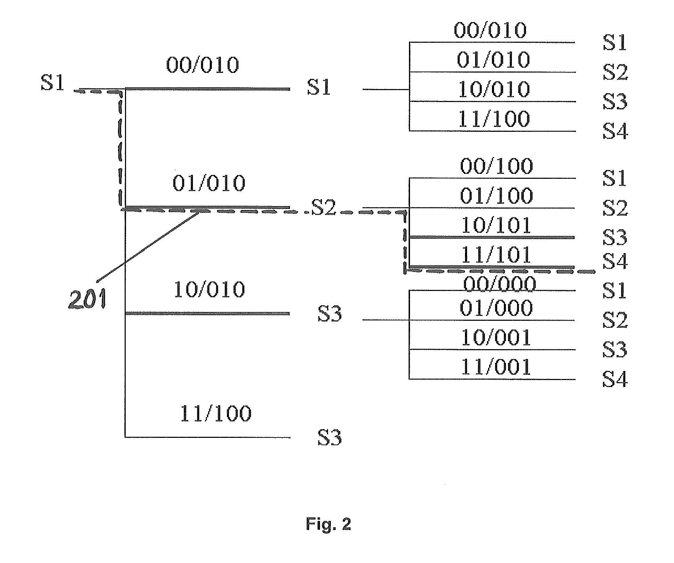

**Fig. 2** shows, as an example, the encoding tree starting from S1 in Table 1. Among the four possible state transitions starting in S1 and depicted in the left half of **Fig. 2**, the first 3, namely S1 -> S1, S1 -> S2, and S1 -> S3, are investigated further, because the associated codeword is "010", which has a potential to be part of an RMTR sequence, i.e. an increase of the RMTR value is possible for these 3 paths. The fourth path "11/100" transiting to S3 is not investigated further, because the associated codeword "100" can not be part of an RMTR sequence, i.e. an increase of the RMTR value is impossible there.

Looking at the subsequent state transitions depicted in the right half of **Fig. 2**, there are only two paths to be extended, corresponding to the state transition sequences {S1, S2, S3} and {S1, S2, S4}, respectively. In **Fig. 2**, they are denoted by bold lines. Note that, because of dealing with three bit codewords, codewords along a path must alternatingly be 010 and 101, if the path is to be extended.

Extending this procedure further, it is found that after four consecutive state transitions, the maximal RMTR value 5 is reached. The corresponding state sequence is {S1, S2, S4, S5, S3}, and the codeword sequence is {010 101 010 101}, as described above. The state sequence {S1, S2, S4, S5, S3} constitutes an RMTR path 201, of which only the beginning state sequence (S1, S2, S4) is visible in Fig. 2.

After examining all states in Table 1, it is found that the overall maximal RMTR value is r=5, and also that there is only one path resulting in the overall maximal RMTR, namely the path {S1, S2, S4, S5, S3} as described above and as shown in **Fig. 1.**

Step 2: For each RMTR path 201 identified in Step 1), re-direct the constituent state transitions, i.e. the state transitions along the RMTR path 201, one by one and independently, to a new state with an aim to reduce the RMTR of the investigated path.

For each possible way of re-direction, the subsequent states/codewords for the new appended state are then determined based on three conditions:

Condition 1: The d-constraint must be maintained. With other words any candidate subsequent state transition which would generate, in its output bit sequence, a violation of the minimum runlength constraint, is rejected.

Condition 2: The k-constraint must not be unlimited. With other words any candidate subsequent state transition which would generate in its output bit sequence an unlimited number of "0" output bits, is rejected.

Condition 3: The RMTR value with the re-direction must be smaller than the original RMTR for the considered path.

Each association of subsequent states and codewords thus found fulfills all three conditions, and constitutes a candidate extended FSM, which will also be denoted as an "FSM assignment" in the following. Among the candidate FSM assignments, those FSM assignments must next be identified, which guarantee decodability for all possible infoword sequences; they will be termed "valid FSM assignments" in the following. These steps will be further explained below using the illustrative example.

A state merging procedure is carried out for each valid FSM assignment. If the FSM assignment obtained after state merging is different from previously stored FSM assignments, it is stored.

For the example code considered above, a new state S6 is introduced to reduce the RMTR value of the single identified RMTR path 201. Formally, an RMTR path comprising 5 states has 4 state transitions, hence, 4 cases of state transition redirection must be investigated. However, only the first 3 of these cases are suitable for re-directing state transitions along the RMTR path 201:

The state transition S1 -> S2 can be redirected to S1 -> S6.

The state transition S2 -> S4 can be redirected to S2 -> S6.

The state transition S4 -> S5 can be redirected to S4 -> S6.

Note that re-directing the state transition S5 -> S3 to S5 -> S6 will not change the RMTR value, hence is not suitable.

Therefore, only the first three cases are taken into account during the re-directing procedure, they are denoted as "redirecting cases" below.

For these three redirecting cases, the - yet incomplete - state transition tables are as follows:

Table 2.1 Incomplete state transition table for the case of redirecting S1->S2 to S1->S6

|     | 00     | 01           | 10     | 11     |
|-----|--------|--------------|--------|--------|
| S1  | 010/S1 | **010/S6**   | 010/S3 | 100/S3 |
| S2  | 100/S1 | 100/S2       | 101/S3 | 101/S4 |
| S3  | 000/S1 | 000/S2       | 001/S3 | 001/S4 |
| S4  | 010/S1 | 010/S5       | 010/S3 | 000/S3 |
| S5  | 100/S1 | 100/S2       | 101/S3 | 000/S3 |
| S6  |        |              |        |        |

Table 2.2 Incomplete state transition table for the case of redirecting S2->S4 to S2->S6

|     | 00     | 01     | 10     | 11         |
|-----|--------|--------|--------|------------|
| S1  | 010/S1 | 010/S2 | 010/S3 | 100/S3     |
| S2  | 100/S1 | 100/S2 | 101/S3 | **101/S6** |
| S3  | 000/S1 | 000/S2 | 001/S3 | 001/S4     |
| S4  | 010/S1 | 010/S5 | 010/S3 | 000/S3     |
| S5  | 100/S1 | 100/S2 | 101/S3 | 000/S3     |
| S6  |        |        |        |            |

Table 2.3 Incomplete state transition table for the case of redirecting S4->S5 to S4->S6

|  | 00 | 01 | 10 | 11 |
|---|---|---|---|---|
| S1 | 010/S1 | 010/S2 | 010/S3 | 100/S3 |
| S2 | 100/S1 | 100/S2 | 101/S3 | 101/S4 |
| S3 | 000/S1 | 000/S2 | 001/S3 | 001/S4 |
| S4 | 010/S1 | **<u>010/S6</u>** | 010/S3 | 000/S3 |
| S5 | 100/S1 | 100/S2 | 101/S3 | 000/S3 |
| S6 |  |  |  |  |

Note that, except at one modified table entry that is marked in boldface underlined, and except the added new state S6, Tables 2.1, 2.2, and 2.3 are identical to Table 1 above.

The subtask now is to fill out the last row in Tables 2.1, 2.2, and 2.3 with a valid assignment, if possible. With other words, the state transition tables must be completed; i.e. state transitions and associated output codewords must now be assigned, for each redirecting case, to the added state S6. This is done using the three conditions mentioned above. Note that checking Condition 1 and Condition 2 is straightforward. For checking Condition 3, the procedure presented in Step 1) is employed to check whether an assigned next state/codeword pair will result in a RMTR larger than or equal to the original RMTR for the investigated path.

The procedure conceptually is as follows:

- First a set of candidate [next state, codeword] pairs is determined. Already in this step, i.e. without having decided yet on the specific assigments for the added state, Condition 1 and Condition 2 described above enable to reduce the set, hence to reduce the number of possibilities to be investigated subsequently.

- Then, candidate assignments to fill the state transition table for the added state are systematically picked from the set of candidate [next state, codeword] pairs.

- The candidate assignments are then checked for distinguishability, i.e. for decodability.

This shall now be illustrated for the example encoder FSM: The code has 6 states and its codewords comprise 3 bits, hence an exhaustive set of candidate [next state, codeword] pairs comprises 6*8=48 pairs at the beginning. But, using Condition 1 and Condition 2, and taking into account that the redirected state transition has an assigned codeword of "010", and that the assigments of states S1 to S5 are as they are, the set of candidate [next state, codeword] pairs to pick from is reduced to {000/S1, 010/S1, 100/S1, 000/S2, 100/S2, 000/S3, 001/S3, 010/S3, 100/S3, 101/S3, 000/S4, 001/S4, 010/S4, 100/S4, 000/S5, 010/S5, 100/S5, 001/S6, 010/S6, 100/S6}. With other words, of the originally 48 pairs, only 20 pairs, which fulfil Condition 1 and Condition 2, are thus left in a reduced set of pairs.

To illustrate some examples of pairs being eliminated or skipped:

Pairs 001/S1 and 101/S1 must be eliminated from the set because when transiting to S1, an infoword exists, namely "11", where a codeword starting with "1" is being output. A state transition 001/S1 followed by a state transition 100/S3 would generate an output bit sequence of 001100, which constitutes a violation of the d=1 constraint.

Pair 010/S2 must be eliminated because in S2 infowords exist, namely "10" and "11", where a codeword "101" is being output, which may be part of a RMTR sequence. A transition 010/S2 followed by 101/** would constitute a prolonged RMTR sequence.

From the reduced set of pairs, four distinct members need to be picked for completing the last row of Table 2.1. Each distinct quadruplet thus picked, taken together with the already given table elements, constitutes one possible 6-state encoding FSM assignment, but it may be an invalid one with respect to decodability. For picking 4 distinct elements out of a set of 20, there are $\begin{pmatrix} 20 \\ 4 \end{pmatrix} = 4845$ possibilities. In general, if M denotes the number of elements in the set, i.e. its cardinality, then for completing one added state in a rate 2/3 encoder FSM, $\begin{pmatrix} M \\ 4 \end{pmatrix}$ combinations have to be tested, whether or not the resulting encoder FSM maintains decodability of arbitrary infoword sequences.

For a candidate FSM assignment, if two different infoword sequences exist, which - starting from one specific state in the encoding FSM - merge into the same state after a finite number of state transitions having the same codeword sequence, these two infoword sequences are indistinguishable, i.e. undecodable with respect to the FSM assignment. Consequently, such an FSM assignment is an invalid assignment because the decoding is impossible.

The concept of indistinguishability was already described in EP08305612.

After examining in this way all 4845 possible assignments for state S6, four Valid Codes are found with r=4.

After performing a state-merging procedure as disclosed in Section V of B.H.Marcus et al, "Finite-state modulation codes for data storage," IEEE JSAC, vol. 10, pp. 5-37, Jan. 1992., the four Valid Codes are as described by the following state transition tables:

Table 3.1: State transition table of the Valid Code 1 after state merging, having (d=1, k=8, r=4).

|  | 00 | 01 | 10 | 11 |
|---|---|---|---|---|
| S1 | 010/S1 | 010/S5 | 010/S3 | 100/S3 |
| S2 | 100/S1 | 100/S2 | 101/S3 | 101/S4 |
| S3 | 000/S1 | 000/S2 | 001/S3 | 001/S4 |
| S4 | 010/S1 | 010/S5 | 010/S3 | 000/S3 |
| S5 | 100/S1 | 100/S2 | 101/S3 | 000/S3 |

Table 3.2: State transition table of the Valid Code 2 after state merging, having (d=1, k=9, r=4).

|  | 00 | 01 | 10 | 11 |
|---|---|---|---|---|
| S1 | 010/S1 | 010/S6 | 010/S3 | 100/S3 |
| S2 | 100/S1 | 100/S2 | 101/S3 | 101/S4 |
| S3 | 000/S1 | 000/S2 | 001/S3 | 001/S4 |
| S4 | 010/S1 | 010/S5 | 010/S3 | 000/S3 |
| S5 | 100/S1 | 100/S2 | 101/S3 | 000/S3 |
| S6 | 100/S1 | 000/S3 | 101/S3 | 100/S5 |

Table 3.3: Sate transition table of the Valid Code 3 after state merging, having (d=1, k=9, r=4).

|  | 00 | 01 | 10 | 11 |
|---|---|---|---|---|
| S1 | 010/S1 | 010/S6 | 010/S3 | 100/S3 |
| S2 | 100/S1 | 100/S2 | 101/S3 | 101/S4 |
| S3 | 000/S1 | 000/S2 | 001/S3 | 001/S4 |
| S4 | 010/S1 | 010/S5 | 010/S3 | 000/S3 |
| S5 | 100/S1 | 100/S2 | 101/S3 | 000/S3 |
| S6 | 100/S1 | 000/S3 | 101/S3 | 100/S6 |

Table 3.4: State transition table of the Valid Code 4 after state merging, having (d=1, k=9, r=4).

|  | 00 | 01 | 10 | 11 |
|---|---|---|---|---|
| S1 | 010/S1 | 010/S6 | 010/S3 | 100/S3 |
| S2 | 100/S1 | 100/S2 | 101/S3 | 101/S4 |
| S3 | 000/S1 | 000/S2 | 001/S3 | 001/S4 |
| S4 | 010/S1 | 010/S5 | 010/S3 | 000/S3 |
| S5 | 100/S1 | 100/S2 | 101/S3 | 000/S3 |
| S6 | 100/S2 | 000/S3 | 101/S3 | 100/S4 |

For Valid Code 1, as a side-effect of the state merging, there are only 5 states in the encoding FSM. From the first state the 4 next states are 1,5,3,3 and the corresponding codewords are 010, 010, 010, 100. For the second state, the next states are 1,2,3,4 associated with codewords 100, 100, 101, 101, and so on. While the k-constraint of the Valid Code 1 remains unchanged as it was in the original code the procedure started with, Valid Codes 2, 3 and 4 all have a slightly increased k-constraint of k=9. In all four Valid Codes, there is only a single RMTR path 201 having r=4.

For redirecting cases 2 and 3, application of the above procedure yields that no valid code is found after the indistinguishability check.

Step 3: Repeat Steps 1), 2) until no further improvement is possible.

For our example, each of the four valid codes with r=4 is in turn used as original code, and the above described procedure is used upon it, hence examining it using Steps 1) and 2). However, it turns out that no further reduction of the RMTR value or of the number of RMTR paths is possible.

Because in Step 2) all valid FSM assignments are being memorized, the design procedure delivers entire sets of RLL codes which may differ, among others, in their RMTR constraints. A stricter, i.e. smaller RMTR constraint typically indicates a higher encoding/decoding complexity. Therefore, appropriate RLL codes can be selected according to application requirements, e.g., RLL codes with the minimal r-parameter and the minimal number of paths resulting in RMTR=r.

Further Examples

In order to find the minimal RMTR-constraint for d=1 FSM encodable RLL codes, the proposed algorithm has been applied to FSM encodable codes with r=5 as presented in EP 08305612. Given the FSM encodable RLL codes with limited RMTRs, the search procedure presented above automatically stores all valid FSM encodable RLL codes with a reduced RMTR-constraint.

For the code disclosed in Table 7.1 of EP 08305612, the procedure of this invention results in 72 FSM encodable RLL codes each having only one r=3 RMTR path. The number of states in the encoding FSMs is between and including 8 and 10. Among these 72 codes, only one has an 8 state FSM as follows:

Table 7.1.1: State transition table for the (d=1, k=9, r=3) code derived from Table 7.1 of **EP 08305612.**

|  | 00 | 01 | 10 | 11 |
|---|---|---|---|---|
| S1 | 010/S2 | 010/S3 | 010/S4 | 000/S6 |
| S2 | 010/S2 | 010/S3 | 010/S4 | 010/S7 |
| S3 | 001/S1 | 001/S3 | 010/S6 | 001/S6 |
| S4 | 100/S2 | 100/S3 | 100/S4 | 100/S5 |
| S5 | 101/S1 | 101/S3 | 100/S6 | 101/S6 |
| S6 | 000/S2 | 000/S3 | 000/S4 | 000/S5 |
| S7 | 000/S6 | 100/S6 | 101/S6 | 101/S8 |
| S8 | 001/S1 | 001/S3 | 000/S6 | 001/S6 |

For the code disclosed in Table 7.2 of EP 08305612, the procedure of this invention results in 49 FSM encodable RLL codes each having only one r=3 RMTR path. The number of states in the encoding FSM is between and including 8 and 10. Among the 49 codes, only one has an 8 state FSM as follows:

Table 7.2.1: State transition table for the (d=1, k=9, r=3) code derived from Table 7.2 of **EP 08305612.**

|  | 00 | 01 | 10 | 11 |
|---|---|---|---|---|
| S1 | 010/S1 | 010/S3 | 010/S4 | 000/S6 |
| S2 | 010/S2 | 010/S3 | 010/S4 | 010/S7 |
| S3 | 001/S1 | 001/S3 | 010/S6 | 001/S6 |
| S4 | 100/S2 | 100/S3 | 100/S4 | 100/S5 |
| S5 | 101/S1 | 101/S3 | 100/S6 | 101/S6 |
| S6 | 000/S2 | 000/S3 | 000/S4 | 000/S5 |
| S7 | 000/S6 | 100/S6 | 101/S6 | 101/S8 |
| S8 | 001/S1 | 001/S3 | 000/S6 | 001/S6 |

For the code disclosed in Table 7.3 of EP 08305612, the procedure of this invention results in 179 FSM encodable RLL codes each having only one r=3 RMTR path. The number of states in the encoding FSM is between and including 8 and 10. Among the 179 codes, there are two codes having an 8 state FSM encoder as follows:

Table 7.3.1: State transition table for the first (d=1, k=9, r=3) code derived from Table 7.3 of **EP 08305612**. The code is identical to the code of Table 7.1.1.

|  | 00 | 01 | 10 | 11 |
|---|---|---|---|---|
| S1 | 010/S2 | 010/S3 | 010/S4 | 000/S6 |
| S2 | 010/S2 | 010/S3 | 010/S4 | 010/S7 |
| S3 | 001/S1 | 001/S3 | 001/S6 | 010/S6 |
| S4 | 100/S2 | 100/S3 | 100/S4 | 100/S5 |
| S5 | 101/S1 | 101/S3 | 101/S6 | 100/S6 |
| S6 | 000/S2 | 000/S3 | 000/S4 | 000/S5 |
| S7 | 000/S6 | 100/S6 | 101/S6 | 101/S8 |
| S8 | 001/S1 | 001/S3 | 000/S6 | 001/S6 |

Table 7.3.2: State transition table for the second (d=1, k=9, r=3) code derived from Table 7.3 of **EP 08305612.**

|  | 00 | 01 | 10 | 11 |
|---|---|---|---|---|
| S1 | 010/S2 | 010/S4 | 000/S6 | 010/S8 |
| S2 | 010/S2 | 010/S3 | 010/S4 | 010/S7 |
| S3 | 001/S1 | 001/S3 | 001/S6 | 010/S6 |
| S4 | 100/S2 | 100/S3 | 100/S4 | 100/S5 |
| S5 | 101/S1 | 101/S3 | 101/S6 | 100/S6 |
| S6 | 000/S2 | 000/S3 | 000/S4 | 000/S5 |
| S7 | 000/S6 | 100/S6 | 101/S6 | 101/S8 |
| S8 | 001/S1 | 001/S3 | 000/S6 | 001/S6 |

For the code disclosed in Table 10.1 of EP 08305612, the procedure of this invention results in 72 FSM encodable RLL codes each having only one r=3 RMTR path. The number of states in the encoding FSM is between and including 8 and 10. Among the 72 codes, there is only one having an 8 state FSM as follows:

Table 10.1.1: State transition table for the (d=1, k=9, r=3) code derived from Table 10.1 of **EP 08305612.**

|  | 00 | 01 | 10 | 11 |
|---|---|---|---|---|
| S1 | 010/S3 | 010/S4 | 010/S5 | 000/S6 |
| S2 | 101/S1 | 101/S4 | 101/S6 | 100/S6 |
| S3 | 100/S2 | 100/S3 | 100/S4 | 100/S5 |
| S4 | 001/S1 | 001/S4 | 001/S6 | 010/S6 |
| S5 | 010/S3 | 010/S4 | 010/S5 | 010/S7 |
| S6 | 000/S2 | 000/S3 | 000/S4 | 000/S5 |
| S7 | 000/S6 | 100/S6 | 101/S6 | 101/S8 |
| S8 | 001/S1 | 001/S4 | 000/S6 | 001/S6 |

For the code disclosed in Table 10.2 of EP 08305612, the procedure of this invention results in 49 FSM encodable RLL codes each having only one r=3 RMTR path. The number of states in the encoding FSM is between and including 8 and 10. Among the 49 codes, there is only one having an 8 state FSM as follows:

Table 10.2.1: State transition table for the (d=1, k=9, r=3) code derived from Table 10.2 of **EP 08305612.**

|  | 00 | 01 | 10 | 11 |
|---|---|---|---|---|
| S1 | 010/S1 | 010/S3 | 010/S4 | 000/S6 |
| S2 | 101/S1 | 101/S4 | 101/S6 | 100/S6 |
| S3 | 100/S2 | 100/S3 | 100/S4 | 100/S5 |
| S4 | 001/S1 | 001/S4 | 001/S6 | 010/S6 |
| S5 | 010/S3 | 010/S4 | 010/S5 | 010/S7 |
| S6 | 000/S2 | 000/S3 | 000/S4 | 000/S5 |
| S7 | 000/S6 | 100/S6 | 101/S6 | 101/S8 |
| S8 | 001/S1 | 001/S4 | 000/S6 | 001/S6 |

For the code disclosed in Table 10.3 of EP 08305612**,** the procedure of this invention results in 179 FSM encodable RLL codes each having only one r=3 RMTR path. The number of states in the encoding FSM is between and including 8 an 10. Among the 179 codes, there are two codes having an 8 state FSM as follows:

Table 10.3.1: State transition table for the first (d=1, k=9, r=3) code derived from Table 10.3 of **EP 08305612.** The code is identical to the code of Table 10.1.1.

|  | 00 | 01 | 10 | 11 |
|---|---|---|---|---|
| S1 | 010/S3 | 010/S4 | 010/S5 | 000/S6 |
| S2 | 101/S1 | 101/S4 | 101/S6 | 100/S6 |
| S3 | 100/S2 | 100/S3 | 100/S4 | 100/S5 |
| S4 | 001/S1 | 001/S4 | 001/S6 | 010/S6 |
| S5 | 010/S3 | 010/S4 | 010/S5 | 010/S7 |
| S6 | 000/S2 | 000/S3 | 000/S4 | 000/S5 |
| S7 | 000/S6 | 100/S6 | 101/S6 | 101/S8 |
| S8 | 001/S1 | 001/S4 | 000/S6 | 001/S6 |

Table 10.3.2: State transition table for the second (d=1, k=9, r=3) code derived from Table 10.3 of **EP 08305612.**

|  | 00 | 01 | 10 | 11 |
|---|---|---|---|---|
| S1 | 010/S3 | 010/S5 | 000/S6 | 010/S8 |
| S2 | 101/S1 | 101/S4 | 100/S6 | 101/S6 |
| S3 | 100/S2 | 100/S3 | 100/S4 | 100/S5 |
| S4 | 001/S1 | 001/S4 | 001/S6 | 010/S6 |
| S5 | 010/S3 | 010/S4 | 010/S5 | 010/S7 |
| S6 | 000/S2 | 000/S3 | 000/S4 | 000/S5 |
| S7 | 000/S6 | 100/S6 | 101/S6 | 101/S8 |
| S8 | 001/S1 | 001/S4 | 000/S6 | 001/S6 |

**Table 3** summarizes all distinct 8 state FSM encodable codes obtained above in a different, shorthand notation. In Table 3, the Table lines marked "nSta=" contain the next state quadruplets for states 1 through 8, and the Table lines marked "Code=" contain the codeword quadruplets for states 1 through 8, wherein the 3 bit codewords are represented here by their decimal equivalent. In that way, "nSta=2346" and "Code=2220" at the beginning of Table 3 stand for "010/S2 010/S3 010/S4 000/S6" in the notation used in Table 7.1.1.

Table 3: Encoder FSMs of all distinct 8 state (d=1, k=9, r=3) codes having only one RMTR path, in shorthand notation.

| Valid Code of Table | Encoding FSM table | | | | | | | |
|---|---|---|---|---|---|---|---|---|
| 7.1.1 | nSta= [2346; | 2347; | 1366; | 2345; | 1366; | 2345; | 8666; | 1366] |
|  | Code= [2220; | 2222; | 1112; | 4444; | 5554; | 0000; | 5540; | 1110] |
| 7.2.1 | nSta= [1346; | 2347; | 1366; | 2345; | 1366; | 2345; | 6668; | 1366] |
|  | Code= [2220; | 2222; | 1121; | 4444; | 5545; | 0000; | 0455; | 1101] |
| 7.3.2 | nSta= [2486; | 2347; | 1366; | 2345; | 1366; | 2345; | 8666; | 1366] |
|  | Code= [2220; | 2222; | 1112; | 4444; | 5554; | 0000; | 5540; | 1110] |
| 10.1.1 | nSta= [1346; | 1466; | 2345; | 1466; | 3457; | 2345; | 6668; | 1466] |
|  | Code= [2220; | 5554; | 4444; | 1112; | 2222; | 0000; | 0455; | 1101] |
| 10.2.1 | nSta= [3456; | 1466; | 2345; | 1466; | 3457; | 2345; | 8666; | 1466] |
|  | Code= [2220; | 5554; | 4444; | 1112; | 2222; | 0000; | 5540; | 1110] |
| 10.3.2 | nSta= [3568; | 1466; | 2345; | 1466; | 3457; | 2345; | 6668; | 1466] |
|  | Code= [2202; | 5545; | 4444; | 1112; | 2222; | 0000; | 0455; | 1101] |

In the context of joint channel detection and RLL decoding, the decoder comprises a copy of the encoder.

However, as shown in M.Noda et al, "An 8-state DC-controllable run-length-limited code for the optical-storage channel", JJAP, vol. 44, No. 5B, pp. 3462-3466, 2005, the encoding FSMs for use in the decoder can be modified from the form of deterministic FSMs or DFSMs into a form called non-deterministic FSMs or NFSMs. This form enables for a reduced compexity of the joint detection/decoding.

For the RLL codes presented in Table 3, **Table 4** shows a comparison of the number of states and the number of state transitions between the DFSM form and the NFSM form of the codes of Table 3. The parameter L denotes the channel memory length of partial response targets used in the joint detector/decoder. Obviously, the complexity employing NFSMs is considerably lower than that employing the DFSM form.

Table 4: Comparison of numbers of states/ numbers of state transitions of the DFSM form and the NFSM form for joint data detection and RLL decoding, for the valid codes shown in Table 3.

| Valid Code | | DFSM | | NFSM | |
|---|---|---|---|---|---|
| | | Number of states | Number of transitions | Number of states | Number of transitions |
| 7.1.1: | L=1 | 16 | 64 | 14 | 54 |
| | L=2 | 20 | 80 | 14 | 54 |
| | L=3 | 28 | 112 | 16 | 56 |
| | L=4 | 44 | 176 | 22 | 80 |
| 7.2.1: | L=1 | 16 | 64 | 14 | 56 |
| | L=2 | 22 | 88 | 14 | 56 |
| | L=3 | 30 | 120 | 16 | 58 |
| | L=4 | 46 | 184 | 22 | 82 |
| 7.3.2: | L=1 | 16 | 64 | 14 | 54 |
| | L=2 | 22 | 88 | 14 | 54 |
| | L=3 | 30 | 120 | 16 | 56 |
| | L=4 | 46 | 184 | 22 | 80 |
| 10.1.1: | L=1 | 16 | 64 | 14 | 56 |
| | L=2 | 22 | 88 | 14 | 56 |
| | L=3 | 30 | 120 | 16 | 58 |
| | L=4 | 46 | 184 | 22 | 82 |
| 10.2.1: | L=1 | 16 | 64 | 14 | 54 |
| | L=2 | 20 | 80 | 14 | 54 |
| | L=3 | 28 | 112 | 16 | 56 |
| | L=4 | 44 | 176 | 22 | 80 |
| 10.3.2: | L=1 | 16 | 64 | 14 | 54 |
| | L=2 | 22 | 88 | 14 | 54 |
| | L=3 | 30 | 120 | 16 | 56 |
| | L=4 | 46 | 184 | 22 | 80 |

With other words, a method is disclosed for deriving channel encoder FSMs of improved noise resilience, as are several channel encoder FSMs derived therewith. In the method, RMTR paths 201 are identified for a given encoder FSM, state transitions of RMTR paths 201 are redirected into an added FSM state, and state transitions from the added state back into the FSM are selected in full search. Full search effort is reduced by applying skipping criteria, and improved noise resilience is achieved by minimizing the number of RMTR paths 201.

**Claims**

1.  Method of modifying a given encoder finite state machine of a channel code obeying a lower runlength limitation, an upper runlength limitation and having repeated minimum transition runlengths constrained to a maximum repetition, into a modified encoder finite state machine having improved noise resilience, the method comprising the steps:

- identifying, as RMTR paths (201), those state transition sequences of the given encoder finite state machine, which generate a codeword sequence containing the maximum repetition of minimum transition runlengths;
- re-directing, in full search, state transitions of an identified RMTR path to an additional state;
- deriving the modified encoder finite state machine by selecting, from a set of next state / codeword assignments, in full search, an assignment for the additional state, where the step of selecting comprises:

    - skipping those assignments where compliance with the lower runlength limitation is not guaranteed,
    - skipping those assignments where an unlimited runlength may arise,
    - skipping those assignments which may generate codeword sequences having a number of repeated minimum transition runlengths larger than the maximum repetition,
    - skipping those assignments which may generate undistinguishable codeword sequences,
    - selecting that assignment whose modified encoder finite state machine has the smallest maximum repetition, and
    - selecting that assignment which minimizes the number of RMTR paths of the modified encoder finite state machine.

2. A method according to claim 1, wherein the step of deriving comprises:

    - reducing a set of candidate next state / codeword pairs by eliminating all those pairs that would cause a violation of the lower runlength limitation or that would cause unlimited runlength,
    - performing the selecting step by picking next state / codeword pairs from the reduced set.

3. A method for channel encoding a sequence of infowords into a sequence of codewords, **characterized in that** the encoder finite state machine is as defined in one of Table 3.1, Table 3.2, Table 3.3, Table 3.4, Table 7.1.1, Table 7.2.1, Table 7.3.2, Table 10.1.1, Table 10.2.1, and Table 10.3.2.

Fig. 1

S1

00/010

S1

00/010 — S1
01/010 — S2
10/010 — S3
11/100 — S4

01/010

S2

00/100 — S1
01/100 — S2
10/101 — S3
11/101 — S4

201

10/010

S3

00/000 — S1
01/000 — S2
10/001 — S3
11/001 — S4

11/100

S3

Fig. 2

Europäisches
Patentamt

European
Patent Office

Office européen
des brevets

# EUROPEAN SEARCH REPORT

Application Number

EP 09 30 5459

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HONG H ET AL: "A New Run-length-limited (2,7) Parity Preserving Code Limiting the Repeated Minimum Transition Run for Optical Storage Systems" JAPANESE JOURNAL OF APPLIED PHYSICS, JAPAN SOCIETY OF APPLIED PHYSICS, TOKYO,JP, vol. 43, no. 7B, 29 July 2004 (2004-07-29) , pages 4879-4881, XP002354238 ISSN: 0021-4922 | 3 | INV. H03M5/14 G11B20/14 |
| A | * abstract * * page 4879, right-hand column * * table 1 * | 1,2 | |
| X | US 5 859 601 A (MOON JAEKYUN [US] ET AL) 12 January 1999 (1999-01-12) | 3 | |
| A | * abstract * * column 4, line 32 - column 5, line 47 * * claim 1 * * figures 2-5 * | 1,2 | |
| A | US 2007/159367 A1 (HIGASHINO SATORU [JP]) 12 July 2007 (2007-07-12) * paragraph [0265] - paragraph [0297] * | 1-3 | |
| A,D | MAKOTO NODA ET AL: "An 8-State DC-Controllable Run-Length-Limited Code for the Optical-Storage Channel" JAPANESE JOURNAL OF APPLIED PHYSICS, JAPAN SOCIETY OF APPLIED PHYSICS, TOKYO,JP, vol. 44, no. 5B, 1 January 2005 (2005-01-01), pages 3462-3466, XP002518924 ISSN: 0021-4922 [retrieved on 2005-05-24] * page 3462, left-hand column - page 3463, left-hand column * | 1-3 | |

TECHNICAL FIELDS
SEARCHED      (IPC)

H03M
G11B

-/--

The present search report has been drawn up for all claims

| Place of search | Date of completion of the search | Examiner |
|---|---|---|
| Munich | 30 March 2010 | Burkert, Frank |

Europäisches
Patentamt

European
Patent Office

Office européen
des brevets

**EUROPEAN SEARCH REPORT**

Application Number

EP 09 30 5459

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2006/030359 A1 (KONINKL PHILIPS ELECTRONICS NV [NL]; COENE WILLEM M J M [NL]; PADIY AL) 23 March 2006 (2006-03-23)<br>* abstract *<br>* page 8, line 26 - page 10, line 19 * | 1,2 | |
| A | JAEKYUN MOON ET AL: "Maximum Transition Run Codes for Data Storage Systems"<br>IEEE TRANSACTIONS ON MAGNETICS, IEEE SERVICE CENTER, NEW YORK, NY, US,<br>vol. 32, no. 5,<br>1 September 1996 (1996-09-01), pages 3992-3994, XP011030883<br>ISSN: 0018-9464<br>* abstract *<br>* page 3992, left-hand column - page 3993, right-hand column * | 1-3 | |
| A,D | COENE W ET AL: "A New d=1, k=10 Soft-Decodable RLL Code with r=2 MTR-Constraint and a 2-to-3 PCWA Mapping for DC-Control"<br>PROC. OPTICAL DATA STORAGE TOPICAL MEETING, 2006 MONTREAL, QUEBEC, CANADA 23-26 APRIL 2006, PISCATAWAY, NJ, USA,IEEE, 23 April 2006 (2006-04-23), pages 168-170, XP010916954<br>ISBN: 978-0-7803-9494-0<br>* the whole document * | 1-3 | TECHNICAL FIELDS SEARCHED (IPC) |

-/--

The present search report has been drawn up for all claims

| Place of search | Date of completion of the search | Examiner |
|---|---|---|
| Munich | 30 March 2010 | Burkert, Frank |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.................................................................................................

& : member of the same patent family, corresponding
document

EPO FORM 1503 03.82 (P04C01)

Europäisches
Patentamt

European
Patent Office

Office européen
des brevets

# EUROPEAN SEARCH REPORT

Application Number

EP 09 30 5459

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | MARCUS B H ET AL: "FINITE-STATE MODULATION CODES FOR DATA STORAGE" IEEE JOURNAL ON SELECTED AREAS IN COMMUNICATIONS, IEEE SERVICE CENTER, PISCATAWAY, US, vol. 10, no. 1, 1 January 1992 (1992-01-01), pages 5-37, XP000462064 ISSN: 0733-8716 * page 10, left-hand column - page 22, left-hand column * ----- | 1,2 | |
| A | EP 1 988 636 A1 (DEUTSCHE THOMSON OHG [DE]) 5 November 2008 (2008-11-05) * abstract * * paragraph [0011] * ----- | 1-3 | |
| | | | **TECHNICAL FIELDS SEARCHED (IPC)** |

The present search report has been drawn up for all claims

| Place of search | Date of completion of the search | Examiner |
|---|---|---|
| Munich | 30 March 2010 | Burkert, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

Application Number

EP 09 30 5459

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

The Search Division considers that the present European patent application does not comply with the requirements of unity of invention and relates to several inventions or groups of inventions, namely:

1. claims: 1, 2

   The subject-matter of claims 1 and 2 relates to a method of modifying the finite state machine of a run-length limited channel code satisfying a repeated minimum transition runlength. The modification includes the identification of RMTR paths and the redirection of said paths to new states. Transitions from the new states to the existing states are selected such that the maximum repetition becomes as small as possible and such that the number of RMTR paths becomes minimum.
   ---

2. claim: 3

   The subject-matter of claim 3 relates to a method of channel encoding, wherein the encoder finite state machine is defined by one of Tables 3.1, 3.2, 3.3, 3.4, 7.1.1, 7.2.1, 7.3.2, 10.1.1, 10.2.1 and 10.3.2 of the description.
   ---

## ANNEX TO THE EUROPEAN SEARCH REPORT
## ON EUROPEAN PATENT APPLICATION NO.

EP 09 30 5459

This annex lists the patent family members relating to the patent documents cited in the above-mentioned European search report.
The members are as contained in the European Patent Office EDP file on
The European Patent Office is in no way liable for these particulars which are merely given for the purpose of information.

30-03-2010

| Patent document cited in search report | | Publication date | Patent family member(s) | | | Publication date |
|---|---|---|---|---|---|---|
| US 5859601 | A | 12-01-1999 | NONE | | | |
| US 2007159367 | A1 | 12-07-2007 | JP | 2007164872 | A | 28-06-2007 |
| WO 2006030359 | A1 | 23-03-2006 | AR | 050743 | A1 | 15-11-2006 |
| | | | AU | 2005283797 | A1 | 23-03-2006 |
| | | | BR | PI0515179 | A | 08-07-2008 |
| | | | CA | 2580388 | A1 | 23-03-2006 |
| | | | CN | 101023586 | A | 22-08-2007 |
| | | | EA | 200700640 | A1 | 31-08-2007 |
| | | | JP | 2008513918 | T | 01-05-2008 |
| | | | KR | 20070054242 | A | 28-05-2007 |
| | | | US | 2008316071 | A1 | 25-12-2008 |
| | | | ZA | 200703062 | A | 27-08-2008 |
| EP 1988636 | A1 | 05-11-2008 | CN | 101359912 | A | 04-02-2009 |
| | | | EP | 1988637 | A2 | 05-11-2008 |
| | | | JP | 2008278497 | A | 13-11-2008 |
| | | | KR | 20080097917 | A | 06-11-2008 |
| | | | US | 2008272940 | A1 | 06-11-2008 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 08305612 A

- WO 06030349 A, Coene
- WO 07072277 A, Coene

**Non-patent literature cited in the description**

- **Narahara et al.** Optical disc system for digital video recording. *Japanese Journal of Applied Physics,* vol. JJAP-39, 912-919
- **B.H.Marcus et al.** Finite-state modulation codes for data storage. *IEEE JSAC,* January 1992, vol. 10, 5-37

- **M.Noda et al.** An 8-state DC-controllable run-length-limited code for the optical-storage channel. *JJAP,* 2005, vol. 44 (5B), 3462-3466